(19) Europäisches Patentamt
European Patent Office
Office européen des brevets

(11) **EP 1 597 827 B1**

(12) **EUROPÄISCHE PATENTSCHRIFT**

(45) Veröffentlichungstag und Bekanntmachung des Hinweises auf die Patenterteilung:
**02.06.2010 Patentblatt 2010/22**

(21) Anmeldenummer: **04711982.1**

(22) Anmeldetag: **18.02.2004**

(51) Int Cl.:
*H03L 7/10* (2006.01)  *H03L 7/187* (2006.01)

(86) Internationale Anmeldenummer:
**PCT/DE2004/000304**

(87) Internationale Veröffentlichungsnummer:
**WO 2004/077676 (10.09.2004 Gazette 2004/37)**

(54) **PHASENREGELANORDNUNG**

PHASE-LOCKING CIRCUIT

DISPOSITIF DE REGLAGE DE PHASE

(84) Benannte Vertragsstaaten:
**DE**

(30) Priorität: **27.02.2003 DE 10308643**

(43) Veröffentlichungstag der Anmeldung:
**23.11.2005 Patentblatt 2005/47**

(73) Patentinhaber: **Infineon Technologies AG**
**85579 Neubiberg (DE)**

(72) Erfinder:
• **MÜNKER, Christian**
**81241 München (DE)**
• **SCHOLZ, Markus**
**81735 München (DE)**

(74) Vertreter: **Viering, Jentschura & Partner**
**Postfach 22 14 43**
**80504 München (DE)**

(56) Entgegenhaltungen:
**EP-A- 1 189 347    WO-A-03/044961**
**US-A- 5 648 744    US-A- 6 111 471**
**US-B1- 6 512 419**

• **PATENT ABSTRACTS OF JAPAN Bd. 2003, Nr. 02, 5. Februar 2003 (2003-02-05) -& JP 2002 314414 A (MATSUSHITA ELECTRIC IND CO LTD), 25. Oktober 2002 (2002-10-25)**

**Beschreibung**

Die vorliegende Erfindung betrifft eine Phasenregelanordnung nach dem Oberbegriff des Patentanspruchs 1.

Eine gattungsgemäße Phasenregelanordnung ist beispielsweise in dem Dokument US 5,648,744 gezeigt. Dort ist ein Oszillator mit mehreren, zu- und abschaltbaren Frequenzbändern gezeigt, die jeweils abstimmbar sind. Die Auswahl des Sub-Bandes erfolgt dabei dadurch, daß die Spannung am Schleifenfilter, also am Eingang des Oszillators und am Ausgang des Phasendetektors, gemessen wird und bei Unterschreiten oder Überschreiten gewisser Grenzen das Frequenzband vergrößert oder verkleinert wird.

Phasenregelschaltungen werden auch als PLL, Phase-Locked Loop, bezeichnet.

Dabei wird normalerweise das Ausgangssignal eines Oszillators nach einer Frequenzteilung mittels eines Phasendetektors mit einem Bezugssignal verglichen, und in Abhängigkeit von dem Phasenvergleich wird über ein Schleifenfilter der steuerbare Oszillator abgestimmt.

Mit derartigen, phasenstarren Regelkreisen werden üblicherweise Signale mit einer gewünschten Frequenz synthetisiert oder beispielsweise ein Taktsignal aus einem Datenstrom rückgewonnen. Außerdem können Phasenregelkreise mit Vorteil im Mobilfunk zu Signalmodulationszwecken verwendet werden.

Der Oszillator des Phasenregelkreises ist normalerweise spannungsgesteuert ausgebildet als sogenannter VCO, Voltage Controlled Oscillator, der eine Ausgangsfrequenz $f_{vco}$ erzeugt, die abhängig von einer Steuerspannung $V_c$ ist. Diese Spannung wird auch als Abstimmspannung bezeichnet. Der Quotient aus der Änderung der Ausgangsfrequenz $\Delta f_{vco}$ zur Änderung der Steuerspannung $\Delta V_c$ wird Steilheit $K_V$ des Oszillators genannt und bestimmt dessen Kennlinie. Die Steilheit kann demnach durch die Formel beschrieben werden:

$$K_V = \frac{\Delta f_{vco}}{\Delta V_C} \; .$$

Die Ausgangsfrequenz eines VCO setzt sich zusammen aus einer variablen Komponente $f_{var}$, die durch die Steilheit und die Steuerspannung bestimmt wird, und einer festen Komponente, der sogenannten Grundfrequenz $f_B$, welche durch die Dimensionierung des VCO festgelegt wird. Die Ausgangsfrequenz $f_{vco}$ ergibt sich demnach durch die Gleichung

$$f_{VCO} = f_B + f_{VAR} = f_B + K_V * V_C \; .$$

Da die Grundfrequenz, bedingt durch Fertigungstoleranzen und Prozeßstreuungen bei der Herstellung des VCO in integrierter Schaltungstechnik, starken Schwankungen unterliegt, muß der variable Anteil $f_{var}$ groß genug sein, um alle Zielfrequenzen trotz der Toleranzen der Grundfrequenz erreichen zu können. Dies läßt sich natürlich mit einem hinreichend großen $K_V$, das heißt mit großer Steilheit gewährleisten, hat jedoch den Nachteil, daß hierdurch die Empfindlichkeit der PLL gegenüber Rauschen und Nebentönen vergrößert ist. Insbesondere ist dies bei hochintegrierten Schaltkreisen problematisch, da über gemeinsame Versorgungsspannungen und gemeinsames Substrat Störungen aus anderen Schaltungsblöcken in den VCO überkoppeln können.

Eine Lösung dieser Problematik wird im eingangs genannten Dokument erreicht durch Vorsehen eines VCO mit umschaltbaren, jeweils abstimmbaren Sub-Bändern. Der gewünschte Frequenzbereich wird dabei mit mehreren Frequenzbändern anstatt mit nur einem einzigen Frequenzband überstrichen. Dabei wird in einem ersten Schritt der VCO so eingestellt, daß die gewünschte Frequenz näherungsweise erreicht wird. In einem zweiten Schritt wird mit der Abstimmspannung $V_C$ der VCO dann innerhalb eines gewählten Sub-Bandes auf die exakte Frequenz gezogen. Hierdurch ergibt sich der Vorteil, daß die Steilheit des VCO innerhalb der einzelnen Sub-Bänder relativ gering ist, so daß die oben beschriebenen Probleme bezüglich Rauschen und Überkopplungen vermieden werden. Besonders gut ist diese Lösung geeignet für hochintegrierte Schaltkreise in komplementärer MOS- oder BiCMOS-Schaltungstechnik, da dort die komplette Meß- und Regellogik strom- und platzsparend auf einem Chip untergebracht werden kann.

In dem Aufsatz von Y. Koo et al.:"A Fully Integrated CMOS Frequency Synthesizer with Charge-Averaging Charge Pump and Dual-Path Loop Filter for PCS- and Cellular-CDMA Wireless Systems", Journal of Solid-State Circuits, Vol. 37, No. 5, May 2002, pp. 536 - 542, ist eine Schaltung beschrieben, bei der das Steuersignal zur Auswahl der gewünschten Sub-Bänder des VCO am Phasendetektor abgegriffen wird. Vorliegend werden die Flanken von Referenzsignal beziehungsweise heruntergeteiltem VCO-Signal am Phasendetektor gezählt und verglichen.

Beiden beschriebenen Schaltungen ist das Prinzip gemeinsam, daß eine von der VCO-Frequenz abgeleitete Größe gemessen wird, nicht die Oszillatorfrequenz selbst. Damit ist zum einen der Nachteil verbunden, daß die VCO-Frequenz am Phasendetektor bereits um den Teilerfaktor n des Frequenzteilers reduziert ist, wodurch die Frequenzauflösung reduziert beziehungsweise die benötigte Meßzeit erhöht ist. Außerdem sind bei Messungen von analogen Größen wie der Schleifenfilterspannung weitere analoge Schaltungsblöcke zur Signalverarbeitung nötig. Weiterhin wird bei Betrieb der PLL als sogenannter Fractional N-Frequenzsynthesizer der Teilerfaktor N einmal je Referenzperiode variiert. Der dadurch hervorgerufene systematische Fehler muß in der Regelung in aufwendiger Weise berücksichtigt werden.

Programmierbare Teiler für hohe Frequenzen sind aus Geschwindigkeitsgründen normalerweise stets als Dual-Modulus-Teiler oder als Multi-Modulus-Teiler ausgeführt.

Ein derartiger, programmierbarer Frequenzteiler ist beispielsweise in dem Dokument C. S. Vaucher et al.:"A Family of Low-Power Truly Modular Programmable Dividers in Standard 0.35μm CMOS Technology" angegeben. Aus diesem Aufsatz ist ersichtlich, daß programmierbare Hochfrequenz-Teiler nicht unmittelbar ausgelesen werden können.

In dem Dokument US 5,182,528 wird die Frequenz des Oszillators über einen Frequenzzähler bestimmt. Ein Mikrocomputer liefert die digitalen Steuersignale und die analoge Steuerspannung über einen aufwendigen Digital/Analog-Wandler für den VCO. In dem Dokument ist beschrieben, daß zu der aufwendigen Ansteuerung und dem Auslesen des VCO ein separater Computer erforderlich ist. Außerdem ist die Schaltung nicht als Frequenzsynthesizer geeignet, welche hohen Anforderungen bezüglich des Phasenrauschens genügt, wie sie aber für Mobilfunksysteme wie GMS, Global System For Mobile Communication, oder UTMS, Universal Mobile Telecommunication System, benötigt werden. Weiterhin wird in dem beschriebenen Dokument kein echter Phasenvergleich, sondern lediglich ein Frequenzvergleich durchgeführt. Dieses aufwendige Auslesen der hohen Frequenz am Ausgang des Oszillators versuchen die Architekturen der übrigen Dokumente, welche bereits erläutert wurden, eben durch Ermitteln der Ausgangsfrequenz des VCO am Phasendetektor zu umgehen.

Auch in dem Dokument A. Kral, F. Behbahani und A. A. Abidi "RF-CMOS Oscillators With Switched Tuning" ist ein VCO mit umschaltbaren Sub-Bändern gezeigt.

Das Dokument EP 1 189 347 A1 zeigt einen spannungsgesteuerten Oszillator mit einer Kapazitätsbank. Die Steuerung erfolgt unter anderem über einen digitalen Signalprozessor mit einem Frequenzmessgerät, das über einen Frequenzteiler an den VCO-Ausgang angeschlossen ist.

Patentveröffentlichung US 6512419-B1 offenbart ein Verfahren und eine Einrichtung zur Abstimmung und Kalibrierung eines Mehrband-VCO unter Verwendung einer Schaltung zur Frequenzmessung die unmittelbar an den Ausgang des Oszillators angeschlossen is.

Aufgabe der vorliegenden Erfindung ist es, eine gattungsgemäße Phasenregelanordnung so weiterzubilden, daß diese hohen Anforderungen an das Phasenrauschen genügt, mit geringem Aufwand realisierbar ist und in Mobilfunkgeräten einsetzbar ist.

Erfindungsgemäß wird die Aufgabe gelöst durch eine Phasenregelanordnung mit den Merkmalen des Patentanspruchs 1. Vorteilhafte Weiterbildungen ergeben sich aus den Unteransprüchen.

Gemäß dem vorgeschlagenen Prinzip ist ein auslesbarer Frequenzzähler vorgesehen, der einen Zählereingang hat, der unmittelbar an den Ausgang des Oszillators angeschlossen ist und der einen Zählwertausgang hat, an dem ein Zählwert auslesbar ist. Weiterhin ist eine Steuereinheit vorgesehen zur Steuerung des abstimmbaren Oszillators, das heißt zur Auswahl des jeweiligen Frequenzbandes des abstimmbaren Oszillators. Die Steuereinheit hat hierfür einen Eingang, der mit dem Zählwertausgang des auslesbaren Frequenzzählers verbunden ist, und einen Ausgang, der an den Auswahleingang des abstimmbaren Oszillators zur Auswahl des Frequenzbandes angeschlossen ist.

Gemäß dem vorgeschlagenen Prinzip sind der auslesbar ausgelegte Frequenzzähler, in dessen Abhängigkeit das Frequenzband des Oszillators eingestellt wird, und der Abwärts-Frequenzumsetzer in dem eigentlichen Phasenregelkreis, der den Ausgang des Oszillators mit dem Phasendetektor koppelt, als separate Funktionsblöcke ausgeführt.

Damit ist es möglich, den Abwärts-Frequenzumsetzer programmierbar auszulegen, während der Frequenzzähler auslesbar ausgeführt ist.

Mit Vorteil können der Abwärts-Frequenzumsetzer und der auslesbar ausgeführte Frequenzzähler unabhängig voneinander im Hinblick auf die jeweiligen Erfordernisse optimiert werden.

Der Abwärts-Frequenzumsetzer ist bevorzugt zur Frequenzteilung als programmierbarer Zähler ausgeführt.

Weiter bevorzugt ist der Abwärts-Frequenzumsetzer als sogenannter Multi-Modulus-Teiler oder zumindest als Dual-Modulus-Teiler ausgebildet, so daß im Mittel über der Zeit ein gebrochen-rationales Teilerverhältnis an dem Abwärts-Frequenzumsetzer einstellbar ist. Damit ist es mit Vorteil möglich, die beschriebene Phasenregelanordnung als ∑Δ-Fractional-N-Synthesizer zu betreiben.

Bevorzugt sind der abstimmbare Oszillator und der auslesbar ausgelegte Frequenzzähler auf dem gleichen Chip integriert.

Damit ist ein besonders präzises Erfassen der Frequenz des Oszillators an dessen Ausgang mit dem auslesbaren Frequenzzähler möglich. Mit dem auslesbaren Frequenzzähler wird bevorzugt jede Flanke des Oszillator-Ausgangssignals ausgewertet.

Neben der aktuellen Oszillatorfrequenz läßt sich mit der gleichen Methode auch die Steilheit des Oszillators messen. Hierfür werden mehrere feste Steuerspannungen an den Oszillator angelegt und die jeweilig resultierenden Frequenzen gemessen. Aus diesen Frequenzen läßt sich bei Kenntnis der angelegten Abstimmspannungen ein Maß für die Steilheit des Oszillators im jeweiligen Frequenzband ableiten. Die Einstellung der Oszillator-Abstimmspannung läßt sich beispielsweise durch Modifikation des Phasendetektors erzielen dahingehend, daß Signale mit festem Puls-Pausen-Verhältnis erzeugt werden, aus denen das Schleifenfilter definierte Gleichspannungen erzeugt.

Der auslesbar ausgelegte Frequenzzähler ist ein asynchroner Binärzähler mit einem flüchtigen Ausgangsregister, einem sogenannten Latch. Das Latch dient zum Auslesen des Zählwerts des Frequenzzählers.

Asynchrone Binärzähler sind mit Vorteil einfach aufbaubar, beispielsweise mit Flip-Flop-Ketten. Asynchronzähler sind auch bei hohen Frequenzen leicht zu realisieren. Die Laufzeiten innerhalb des Zählers können beim Auslesen des Zählwerts problemlos berücksichtigt werden.

Die Steuereinheit zur Ansteuerung des Oszillators bezüglich der Wahl des Frequenzbandes und der Abwärts-Frequenzumsetzer im Phasenregelkreis haben bevorzugt je einen Soll-Eingang zum Zuführen eines Soll-Frequenzsignals mit der Zielfrequenz. In Abhängigkeit von der gewünschten Zielfrequenz wird demnach sowohl das Frequenz-Teilerverhältnis in der PLL eingestellt, als auch das geeignete Sub-Band des Oszillators.

Der auslesbar ausgeführte Frequenzzähler hat bevorzugt einen Steuereingang zur Einstellung der Frequenzauflösung, der mit einem zugeordneten Steuerausgang der Steuereinheit verbunden ist. Damit kann der Zähler in Abhängigkeit von der VCO-Frequenz für eine vorgegebene Torzeit (auch Gating-Zeit genannt) angesteuert werden und der Zählerstand ausgelesen werden. Durch die Wahl der Torzeit läßt sich insbesondere bei Auswertung jeder Signalflanke des Oszillator-Ausgangssignals für jede gewünschte Anwendung der optimale Kompromiß zwischen Meßzeit und Meßgenauigkeit wählen. Die Meßgenauigkeit hängt ausschließlich von der Torzeit ab.

Es ist vorteilhaft, einen Binärzähler zur Frequenzmessung einzusetzen, da hier der Zählerstand im gleichen Format wie der Sollwert vorliegt. Die Sollfrequenz einer PLL wird üblicherweise als Binärwort in Vielfachen der Referenzfrequenz dargestellt, bei Fractional-N PLLs als gebrochenzahliges Vielfaches. Asynchronzähler sind auch für hohe Frequenzen leicht realisierbar, es sollten beim Auslesen lediglich eventuell vorhandene Laufzeiten im Zähler beachtet werden.

Die Erfindung wird nachfolgend an mehreren Ausführungsbeispielen anhand der Zeichnungen näher erläutert.

Es zeigen:

Figur 1    ein Blockschaltbild eines Ausführungsbeispiels des vorgeschlagenen Prinzips,

Figur 2    ein Ausführungsbeispiel eines auslesbaren Frequenz- zählers zur Anwendung in der Phasenregelanordnung von Figur 1,

Figur 3    ein Ausführungsbeispiel eines abstimmbaren Oszilla- tors mit mehreren, jeweils abstimmbaren Sub-Frequenzbändern zur Anwendung in der Phasenregelanord- nung von Figur 1,

Figur 4    die Abstimmcharakteristik des Oszillators von Fi- gur 3 mit mehreren Frequenzbändern, und

Figur 5    eine Weiterbildung der Phasenregelanordnung von Fi- gur 1 mit Schleifenbandbreitenregelung.

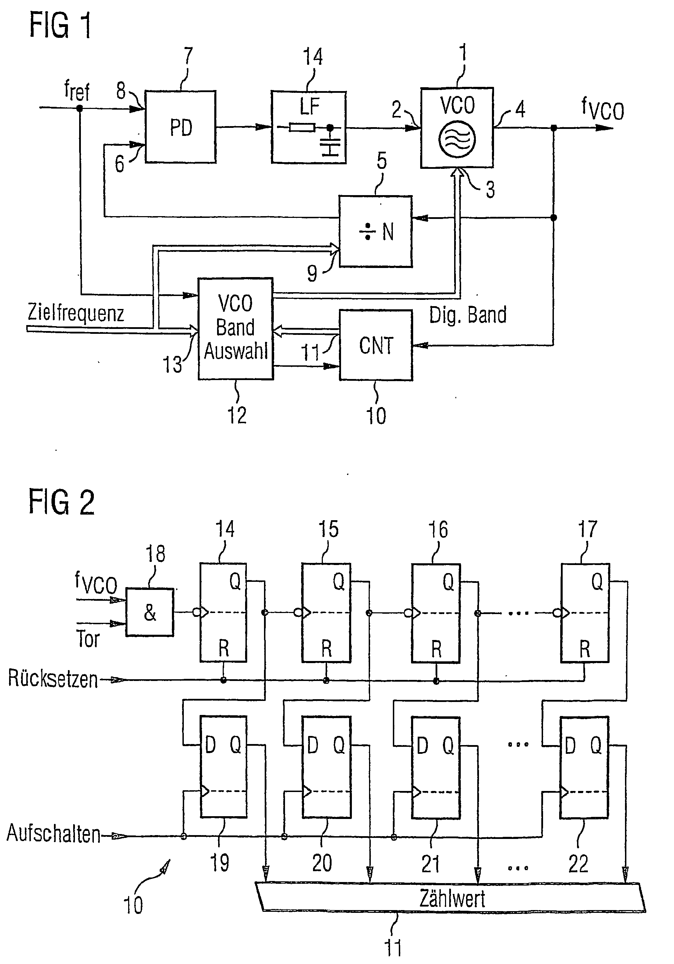

Figur 1 zeigt eine als PLL, Phase-Locked Loop, ausgeführte Phasenregelanordnung mit einem abstimmbaren Oszillator 1, der mehrere, jeweils abstimmbare Frequenzbänder aufweist. Der abstimmbare Oszillator 1 hat einen Abstimmeingang 2, einen Auswahleingang 3 zur Auswahl eines Frequenzbandes in Abhängigkeit von einem Steuersignal und einen Ausgang 4, an dem ein Signal mit der gewünschten Oszillatorfrequenz $f_{vco}$ abgegriffen werden kann. Der Ausgang 4 des Oszillators bildet zugleich den Ausgang der Phasenregelanordnung. Der Ausgang 4 des Oszillators ist über einen programmierbaren Frequenzteiler 5, der eine Abwärts-Frequenzumsetzung bewirkt, an einen Eingang 6 eines Phasendetektors 7 angeschlossen. Dem Phasendetektor 7 wird an einem weiteren Eingang 8 ein Referenzsignal mit einer Referenzfrequenz $f_{ref}$ zugeführt. Zur Einstellung der Oszillatorfrequenz $f_{vco}$ hat der Frequenzteiler 5 einen Programmiereingang 9, an dem in Form eines Soll-Signals die Zielfrequenz oder eine von der Zielfrequenz abgeleitete Information zugeführt wird.

Zusätzlich zu dem programmierbaren Frequenzteiler 5, der als digitaler, programmierbarer Frequenzzähler realisiert ist, ist ein weiterer Frequenzzähler 10 vorgesehen, der mit seinem Zähleingang ebenfalls an den Ausgang 4 des abstimmbaren Oszillators 1 angeschlossen ist. Im Gegensatz zum Frequenzteiler 5 hat der Frequenzzähler 10 einen Zählwertausgang 11, an dem der aktuelle Zählwert des Frequenzzählers 10 oder ein gespeicherter Zählwert ausgelesen werden kann.

Demnach ist der Frequenzteiler 5 programmierbar, nicht jedoch auslesbar ausgeführt, und der Frequenzzähler 10 ist auslesbar, nicht jedoch programmierbar ausgelegt.

Mit einer Steuereinheit 12 wird in Abhängigkeit von der Zielfrequenz der Phasenregelanordnung und des Zählwertes des Zählers 10 die Frequenzbandwahl am Oszillator 1 durchgeführt. Hierfür hat die Steuereinheit 12 einen Eingang, der mit dem Zählwertausgang 11 verbunden ist und einen Ausgang, der an den Auswahleingang 3 des abstimmbaren Oszillators 1 angeschlossen ist. Zudem hat die Steuereinheit 12 einen Steuereingang 13. Die Steuereingänge zur Zielfrequenzzuführung 9, 13 von Frequenzteiler 5 und Steuereinheit 12 sind miteinander zur Zuführung der Soll-Frequenz der Phasenregelanordnung oder eines davon abgeleiteten Signals verbunden.

Der Ausgang des Phasendetektors 7 ist über ein Schleifenfilter 14 mit dem Abstimmeingang 2 des Oszillators 1 gekoppelt. Das Schleifenfilter 14 dient zur Dimensionierung des Regelkreises der PLL.

Die Steuereinheit 12 hat einen Eingang zur Zuführung der Bezugsfrequenz $f_{ref}$, welche auch am Eingang 8 des Phasendetektors 7 anliegt.

Die Besonderheit der vorliegenden Schaltung ist es, daß die VCO-Frequenz mit einem separaten Zähler 10 gemessen wird, der unmittelbar an den Ausgang 4 des Oszillators 4 angeschlossen und auf dem gleichen Chip wie der Oszillator 1 angeordnet ist. Dadurch ist eine direkte Messung der Oszillatorfrequenz, welche somit hochpräzise ist, zugleich in sehr schneller Weise möglich. Der Zähler 10 ist nicht programmierbar und kann daher auch für hohe Eingangsfrequenzen mit einfachem Aufbau so realisiert werden, daß der Zählwert auslesbar ist.

Derartige Zähler wie der Frequenzzähler 10 lassen sich beispielsweise in modernen CMOS-Schaltungstechniken auch für den Gigahertz-Frequenzbereich problemlos integrieren. Folglich können Messung und Abgleich vollständig auf dem gleichen Chip durchgeführt werden, ohne das hochfrequente Oszillatorsignal externen Meßvorrichtungen zuführen zu müssen. Da der separate Zähler 10 parallel zur eigentlichen Phasenregelanordnung 1, 5, 7, 14 läuft, sind auch keine Eingriffe in performancekritische Funktionsblöcke der PLL wie Frequenzteiler mit Prescaler oder Phasendetektor notwendig. Der Vergleich zwischen Zielfrequenz und Ist-Frequenz in der Steuereinheit 12 läßt sich besonders leicht durchführen, wenn die Torzeit von der Referenzperiode abgeleitet ist. Der eigentliche Algorithmus, mit dem das Frequenzband des Oszillators in Abhängigkeit vom Zählerstand des Zählers 10 gestellt oder geregelt wird, ist nicht mit dem Meßverfahren verknüpft und läßt sich je nach Anforderung unabhängig vom Meßverfahren wählen.

Der Zähler 10 wird mit der Oszillatorfrequenz $f_{vco}$ für eine vorgegebene Torzeit $\Delta T_{Gate}$ angesteuert und der Zählerstand CNT ausgelesen. Dies erfolgt nach der Vorschrift

$$f_{VCO} = \frac{CNT}{\Delta T_{Gate}} \ .$$

Da jede Flanke des Oszillators 1 ausgewertet wird, läßt sich durch Wahl der Torzeit $\Delta T_{Gate}$ für jede Anwendung der beschriebenen Phasenregelanordnung ein optimaler Kompromiß finden zwischen Meßzeit und Meßgenauigkeit. Die Meßgenauigkeit wird ausschließlich durch die Torzeit bestimmt.

Die Meßungenauigkeit $\Delta f$ ergibt sich gemäß der Formel

$$\Delta f = \frac{1}{\Delta T_{Gate}}$$

Wenn die Torzeit aus der Referenzperiode abgeleitet wird, das heißt in Abhängigkeit von der Bezugsfrequenz $f_{ref}$ ermittelt wird, kann der Zählwert auf einfache Weise mit der Zielfrequenz verglichen werden. Dabei kann der Frequenzteiler 5 auch als Fractional-N-Teiler ausgeführt sein.

Mit der beschriebenen Phasenregelanordnung ist es auch möglich, die jeweilige VCO-Steilheit zu messen, indem die VCO-Frequenz mit zwei oder mehr verschiedenen, festen Steuerspannungen am Abstimmeingang 2 nacheinander eingestellt wird und die resultierenden jeweiligen Frequenzen gemessen werden. Aus diesen Frequenzwerten läßt sich ein Maß für die Steilheit des VCO im jeweiligen Frequenzband ableiten.

Die beschriebene digitale Regelung des geeigneten Sub-Frequenzbandes erfolgt demnach mit vorgeschlagenem Prinzip sehr schnell mit kurzer Stellzeit. Dies ist insbesondere bei Anwendung in Systemen, die mit Zeit-Multiplexing arbeiten, wie beispielsweise GSM, vorteilhaft, da dort die Frequenz zwischen den Zeitschlitzen sehr schnell einen neuen Wert erreichen soll.

Je nach Anforderung kann der Oszillator einige wenige oder auch mehrere tausend Sub-Bänder umfassen. Die vorgeschlagene Regelung arbeitet genau genug, um das richtige Sub-Band des VCO zu treffen, welches die gewünschte Zielfrequenz umfaßt. Die vorliegende Regelung ist robust genug, um das richtige Band zu treffen, auch dann, wenn die Änderung der Frequenz nicht ideal linear oder monoton über das digitale Steuerwort verläuft.

Da aufgrund der Vielzahl der einstellbaren Sub-Bänder eine flache Steilheit im Oszillator vorgesehen ist, können problemlos die hohen Anforderungen von Mobilfunkstandards an das Phasenrauschen erfüllt werden. Mit dem auslesbaren Zähler 10 ist die durch die hohe Anzahl von Bändern erforderliche hohe Meßauflösung problemlos bei zugleich kurzen Meßzeiten gewährleistet.

Da wie bereits beschrieben auch die Steilheit des VCO ermittelt und gegebenenfalls korrigiert werden kann, können mit Vorteil auch eventuelle Einflüsse der Steilheit auf die Schleifenverstärkung und/oder Schleifenbandbreite berücksichtigt werden.

Der Vergleich von Soll- und Ist-Wert der Frequenz ist vorliegend mit einem digitalen Komparator von Soll- und Ist-Wert realisiert. Alternativ kann aber auch eine Subtraktion von Soll- und Ist-Wert zum Einsatz kommen. Ebenso ist es möglich, eine Überprüfung des Vorzeichenbits eines Rückwärtszählers durchzuführen, der mit dem Zählwert für die Sollfrequenz geladen wird.

Die Steuereinheit 12 ist im vorliegenden Ausführungsbeispiel ausgelegt zur Einstellung des jeweils richtigen Frequenzbandes mittels des Verfahrens der sukzessiven Approximation. Dabei erfolgt die Approximation abhängig davon, ob die Ist-Frequenz größer ist oder kleiner als die Zielfrequenz. In Abhängigkeit von dem Vergleichsergebnis wird die Oszillatorfrequenz digital nachgeregelt. Dieses Prinzip funktioniert mit Vorteil auch bei stark veränderlichen, nichtlinearen Oszillator-Frequenzcharakteristika. Die Anzahl der Iterationsschritte berechnet sich aus dem Logarithmus dualis der Gesamtzahl der VCO-Sub-Bänder.

Alternativ zur sukzessiven Approximation könnte in der Steuereinheit 12 eine Tabelle hinterlegt sein, mit der aus der Frequenzabweichung des Oszillators das richtige Band ermittelt wird.

Eine weitere Möglichkeit der Bestimmung des Oszillatorbandes ist mit einem Algorithmus gegeben, der aus der Frequenzabweichung der VCO das richtige Band berechnet.

Außerdem könnte alternativ auch ein Zählverfahren oder Wägeverfahren zum Einsatz kommen, welches abhängig davon, ob die Ist-Frequenz größer ist oder kleiner als die Zielfrequenz, das Oszillatorwort um 1 vergrößert oder um 1 reduziert. Auch dieses Verfahren funktioniert bevorzugt bei stark veränderlicher, nichtlinearer VCO-Frequenz-Charakteristik. Es werden maximal soviele Iterationen benötigt, wie der Oszillator Sub-Bänder hat. Dieses Verfahren ist besonders einfach implementierbar.

Figur 2 zeigt einen asynchronen Binärzähler 10, wie er in der Phasenregelanordnung gemäß Figur 1 einsetzbar ist. Der asynchrone Binärzähler umfaßt eine Vielzahl von hintereinandergeschalteten Flip-Flops 14, 15, 16, 17, welche jeweils einen Takteingang, einen Rücksetzeingang R und einen Ausgang Q haben. Der Takteingang des eingangsseitigen Flip-Flops 14 ist an den Ausgang eines UND-Gatters 18 geschaltet, dessen Eingänge einerseits mit dem Ausgang 4 des Oszillators 1 und andererseits mit einem Steuerausgang der Steuereinheit 12 zur Steuerung der Torzeit oder Gate-Zeit verbunden sind. Die Takteingänge der nachfolgenden Flip-Flops 15, 16, 17 sind jeweils mit dem Ausgang Q des vorangeschalteten Flip-Flops 14, 15, 16 verbunden. Die Rücksetzeingänge R sind miteinander und einem Rücksetzeingang des Zählers 10 verbunden, der ebenfalls mit einem Steuerausgang der Steuereinheit 12 verbunden ist. Jedem Flip-Flop 14, 15, 16, 17 ist ein als Latch arbeitendes D-Flip-Flop 19, 20, 21, 22 zugeordnet und mit seinem Dateneingang an den Ausgang Q des Zähl-Flip-Flops 14, 15, 16, 17 angeschlossen. Die Takteingänge der D-Flip-Flops 19 bis 22 sind mit einem Aufschalteingang verbunden, der an einen Steuerausgang der Steuereinheit 12 angeschlossen ist und ein Durchschalten des aktuellen Zählwertes auf den Ausgang 11 des Zählers bewirkt. Hierfür sind die Ausgänge Q der D-Flip-Flops 19 bis 22 mit dem Zählwertausgang 11 verbunden.

Besonders einfach wird der Vergleich von Soll- und Ist-Frequenz in der Steuereinheit 12, wenn die Torzeit für den Zähler 10 eine Zweierpotenz $2^k$ der Referenzperiode ist, dann gilt für den Zählerstand CNT:

$$CNT = f_{VCO} \cdot T_{Gate} = f_{VCO} 2^k \cdot T_{ref} = 2^k \cdot \frac{f_{VCO}}{f_{ref}}$$

Der Zählerstand CNT entspricht also dem um k bit nach links verschobenen Verhältnis zwischen VCO-Frequenz und Referenzfrequenz. Wenn der VCO 1 genau auf der Zielfrequenz schwingt, ist der Quotient aus Oszillatorfrequenz und Referenzfrequenz gleich N, also gleich dem programmierten Teilerwert. Zum Vergleich von Soll- und Ist-Frequenz kann daher bei der Torzeit, die dem Produkt aus $2^k$ und der Referenz-Periodendauer $T_{ref}$ entspricht, der Zählerstand CNT mit dem um k bit nach links verschobenen Teilerwert N verglichen werden gemäß der Vorschrift CNT = $2^k$ * N.

Bei Integer-Teilerwerten müssen k Nullen auf den niederwertigen Bits des Teilerwerts aufgefüllt werden. Bei Fractional-N Teilerwerten muß die entsprechende Anzahl Nachkommastellen aufgefüllt werden. Die Frequenzungenauigkeit Δf beträgt lediglich

$$\Delta f = \frac{1}{T_{Gate}} = \frac{f_{ref}}{2^k} \ .$$

Bei integrierten Schaltungen wird normalerweise aus Kostengründen auf externe Abgleichelemente oder zusätzliche Prozeßschritte verzichtet. Daher sind die frequenzbestimmenden Bauelemente normalerweise starken Prozeß- und Temperaturschwankungen ausgesetzt, und es kann kein Abgleichalgorithmus verwendet werden, der die Frequenz-Charakteristik des Oszillators fest einprogrammiert hat, sogenannte Look-Up Tables oder ähnliches. Im Gegensatz dazu setzt der Algorithmus der sukzessiven Approximation, der vorliegend bevorzugt eingesetzt wird, lediglich voraus, daß die Frequenz-über-Band-Charakteristik des VCO keine fehlenden Frequenzbänder aufweist. Störungen der Monotonie oder Nichtlinearitäten sind dagegen unproblematisch.

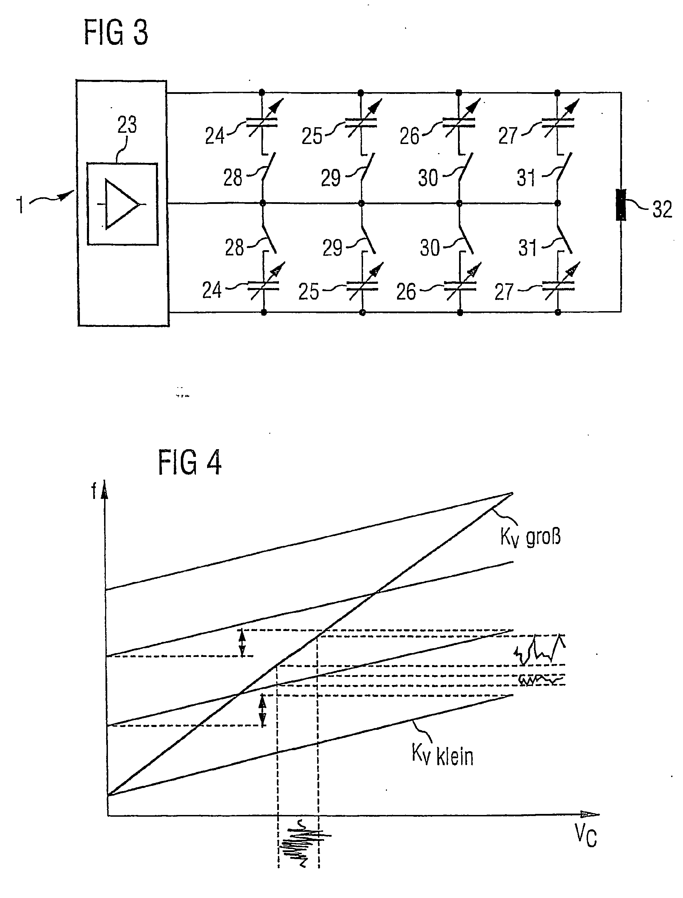

Figur 3 zeigt ein Ausführungsbeispiel eines Multiband-Oszillators 1, wie er in Figur 1 einsetzbar ist. Der Oszillator ist als LC-Oszillator ausgeführt, was bedeutet, daß als schwingfrequenzbestimmende Elemente Induktivitäten 32 und Kapazitäten 24, 25, 26, 27 vorgesehen sind. Zusätzlich ist ein Entdämpfungsverstärker 23 vorgesehen, der als aktives Element für die Bereitstellung einer negativen Impedanz sorgt. An diesen sind in einer Parallelschaltung eine Vielzahl abstimmbarer Kapazitätspaare 24, 25, 26, 27 angeschlossen, wobei die Kapazitäten jeweils doppelt vorgesehen sind und in einer Serienschaltung mit Schaltern 28, 29, 30, 31 angeordnet sind. Diese Serienschaltungen umfassend Varaktoren und Schalter sind zueinander parallel geschaltet. Zu dieser Parallelschaltung ist außerdem eine Induktivität 32 parallel geschaltet. Versorgungs- und Bezugspotentialanschlüsse sind zur Vereinfachung nicht eingezeichnet. Die Varaktoren 24 bis 27 und Schalter 28 bis 31 können beispielsweise alle gleich groß und/oder binär gestaffelt sein. Durch Aktivieren jeweiliger Schalter und damit jeweiliger Varaktoren kann das Frequenzband in gewünschter Weise selektiert werden. Die Ansteuerung der Schalter 28 bis 31 erfolgt mittels der Steuereinheit 12 von Figur 1.

Figur 4 beschreibt die Kennliniencharakteristik des Oszillators 1 von Figur 3. Dabei ist in einem Diagramm die Frequenz über der Abstimmspannung aufgetragen. Mit $K_V$ groß ist die Kennlinie eines VCO bezeichnet, der lediglich genau einen abstimmbaren Frequenzbereich hat. Man erkennt deutlich, daß, um den gesamten Frequenzbereich abdecken zu können, eine verhältnismäßig große Steilheit vorgesehen ist. Wählt man hingegen vier Sub-Bänder, wie in Figur 3 gezeigt, mit denen der gleiche Frequenzbereich überstrichen werden kann und die einander leicht überlappen, damit keine fehlenden Frequenzbänder auftreten, so erkennt man, daß die Steilheit $K_v$ klein vorteilhafterweise viel kleiner sein kann und damit der Oszillator ein sehr viel geringeres Phasenrauschen hat.

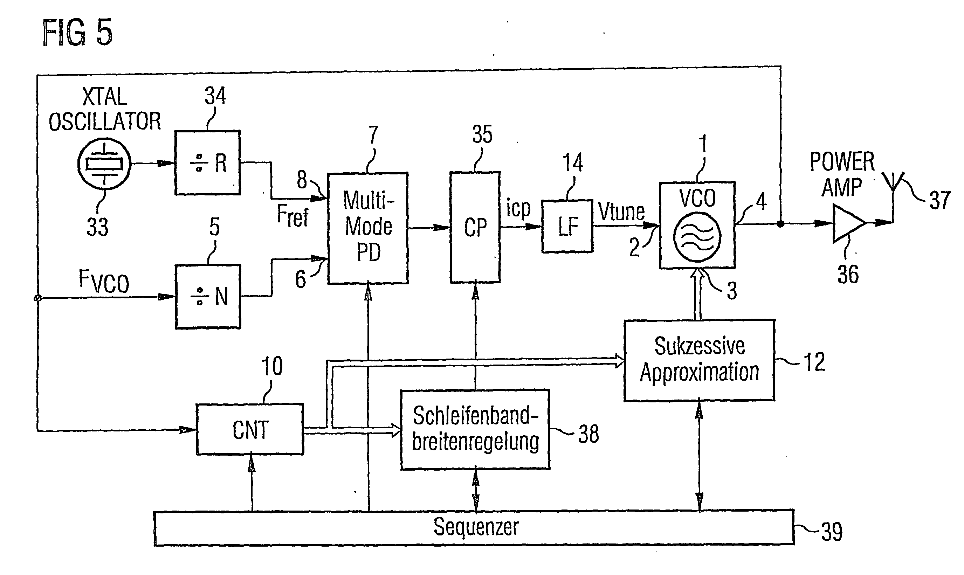

Figur 5 zeigt eine Weiterbildung der Phasenregelanordnung von Figur 1, bei der zusätzlich eine Schleifenbandbreitenregelung vorgesehen ist. Die Schaltung von Figur 5 entspricht weitgehend der von Figur 1 und wird insoweit an dieser Stelle nicht noch einmal beschrieben. Zusätzlich ist bei Figur 5 am Eingang 8 des Phasendetektors 7 ein Quarz-Oszillator 33 vorgesehen, der über einen Bezugsfrequenzteiler 34 zur Bereitstellung der Bezugsfrequenz $f_{ref}$ an den Eingang 8 des Phasendetektors 7 angeschlossen ist. Der Phasendetektor 7 ist vorliegend über eine Ladungspumpenschaltung 35 an den Eingang des Schleifenfilters 14 angeschlossen. Der Ausgang 4 der Phasenregelanordnung ist über einen Leistungsverstärker 36 an eine Antenne 37 gelegt. Der Ausgang des Frequenzzählers 10, ausgelegt zum Auslesen des Zählwertes, ist nicht nur mit einem Eingang der Steuereinheit 12 verbunden, sondern auch mit einem Schleifenbandbreitenregelungsblock 38, der zur Steuerung der Ladungspumpe 35 mit dieser verbunden ist. Zähler 10, Phasendetektor 7, Schleifenbandbreitenregelblock 38 und Steuereinheit 12 sind, teilweise bidirektional, mit einer Ablaufsteuerung 39 gekoppelt.

Für die Schleifenbandbreitenregelung wird ebenfalls eine hochgenaue und schnelle Messung der Oszillatorfrequenz benötigt, so daß diese bei geringem Aufwand zu der Schaltung von Figur 1 ergänzbar ist. Mit der vorgeschlagenen Schleifenbandbreitenregelung kann in einfacher Weise eine gegebenenfalls vorhandene unterschiedliche Steilheit des Oszillators in den verschiedenen Frequenzbändern ausgeglichen werden.

Bezugszeichenliste

| | |
|---|---|
| 1 | abstimmbarer Oszillator |
| 2 | Abstimmeingang |
| 3 | Bandwahleingang |
| 4 | Ausgang |
| 5 | Frequenzteiler |
| 6 | Eingang |
| 7 | Phasendetektor |
| 8 | Eingang |

| 9 | Programmiereingang |
|---|---|
| 10 | auslesbarer Frequenzzähler |
| 11 | Zählwertausgang |
| 12 | Steuereinheit. |
| 13 | Eingang |
| 14 | Flip-Flop |
| 15 | Flip-Flop |
| 16 | Flip-Flop |
| 17 | Flip-Flop |
| 18 | UND-Gatter |
| 19 | Flip-Flop |
| 20 | Flip-Flop |
| 21 | Flip-Flop |
| 22 | Flip-Flop |
| 23 | Verstärker |
| 24 | Varaktor |
| 25 | Varaktor |
| 26 | Varaktor |
| 27 | Varaktor |
| 28 | Schalter |
| 29 | Schalter |
| 30 | Schalter |
| 31 | Schalter |
| 32 | Induktivität |
| 33 | Oszillator |
| 34 | Teiler |
| 35 | Ladungspumpe |
| 36 | Verstärker |
| 37 | Antenne |
| 38 | Schleifenbandbreitenregelblock |
| 39 | Ablaufsteuerung |

**Patentansprüche**

1. Phasenregelanordnung, aufweisend

   - einen über einen Abstimmeingang (2) abstimmbaren Oszillator (1) mit mehreren Frequenzbändern und mit einem Auswahleingang (3) zur Auswahl eines Frequenzbands in Abhängigkeit von einem Steuersignal und
   - einen Phasendetektor (7) mit einem ersten Eingang (8) zur Zuführung eines Referenzsignals und mit einem zweiten Eingang (6), der mit einem Ausgang des Oszillators (1) über einen Abwärts-Frequenzumsetzer (5) gekoppelt ist,
   **dadurch gekennzeichnet, daß**
   - ein auslesbar ausgelegter Frequenzzähler (10) vorgesehen ist, mit einem Zählereingang, der unmittelbar an den Ausgang des Oszillators (4) angeschlossen ist, und mit einem Zählwertausgang (11) zum Auslesen eines Zählwerts, daß
   - eine Steuereinheit (12) vorgesehen ist mit einem Eingang, der mit dem Zählwertausgang (11) verbunden ist und mit einem Ausgang, der an den Auswahleingang (3) des abstimmbaren Oszillators angeschlossen ist zur Auswahl eines Frequenzbandes und daß
   - der auslesbar ausgelegte Frequenzzähler (10) ein asynchroner Binärzähler mit einem flüchtigen Ausgangsregister (19, 20, 21, 22) ist.

2. Phasenregelanordnung nach Anspruch 1,
   **dadurch gekennzeichnet, daß**
   der Abwärts-Frequenzumsetzer (5) als programmierbarer Zähler ausgeführt ist.

3. Phasenregelanordnung nach Anspruch 1 oder 2,
   **dadurch gekennzeichnet, daß**

der Abwärts-Frequenzumsetzer (5) als Multi-Modulus-Teiler ausgeführt ist, mit dem im Mittel ein gebrochen-rationales Teilerverhältnis einstellbar ist.

**4.** Phasenregelanordnung nach einem der Ansprüche 1 bis 3,
**dadurch gekennzeichnet, daß**
der abstimmbare Oszillator (1) und der auslesbar ausgelegte Frequenzzähler (10) auf einem gemeinsamen Halbleiterkörper integriert sind.

**5.** Phasenregelanordnung nach einem der Ansprüche 1 bis 4,
**dadurch gekennzeichnet, daß**
die Steuereinheit (12) und der Abwärts-Frequenzumsetzer (5) je einen Soll-Eingang zum Zuführen eines Soll-Frequenzsignals haben.

**6.** Phasenregelanordnung nach einem der Ansprüche 1 bis 5,
**dadurch gekennzeichnet, daß**
der abstimmbar ausgeführte Frequenzzähler (10) einen Steuereingang zur Einstellung der Frequenzauflösung hat, der an einen zugeordneten Steuerausgang der Steuereinheit (12) angeschlossen ist.

**Claims**

**1.** Phase control device, comprising

• an oscillator (1) which is tunable via a tuning input (2) with several wave bands and with a selection input (3) for selecting a wave band depending on a control signal and
• a phase detector (7) with a first input (8) for feeding a reference signal and with a second input (6) that is coupled with an output of the oscillator (1) via a down frequency converter (5), **characterized in that**
• a readable frequency counter (10) is provided with a counter input that is directly connected to the output of the oscillator (4), and with a counting value output (11) for reading out a counting value, that
• a control unit (12) is provided with an input which is connected to the counting value output (11) and to an output which is connected to the selection input (3) of the tunable oscillator for selection of a wave band and that
• the readable frequency counter (10) is an asynchronous binary counter with a volatile output register (19, 20, 21, 22).

**2.** Phase control device according to claim 1, **characterized in that** the down frequency converter (5) is realized as programmable counter.

**3.** Phase control device according to claim 1 or 2, **characterized in that** the down frequency converter (5) is executed as multi modulus divider with which on average a fractured rational dividing ratio is adjustable.

**4.** Phase control device according to one of claims 1 to 3, **characterized in that** the tunable oscillator (1) and the readable frequency counter (10) are integrated on a common semiconductor body.

**5.** Phase control device according to one of claims 1 to 4, **characterized in that** the control unit (12) and the down frequency converter (5) have respectively a target input for feeding a target frequency signal.

**6.** Phase control device according to one of claims 1 to 5, **characterized in that** the tunable frequency counter (10) has a control input for adjusting the frequency dissolution which is connected to an allocated control output of the control unit (12).

**Revendications**

**1.** Dispositif de réglage d'asservissement, comprenant

- un oscillateur (1) accordable par une entrée (2) d'accord et ayant plusieurs bandes de fréquence et une entrée (3) de sélection pour la sélection d'une bande de fréquence en fonction d'un signal de commande et
- un détecteur (7) de phase ayant une première entrée (8) pour l'admission d'un signal de référence et une deuxième entrée (6), qui est couplée à une sortie de l'oscillateur (1) par un convertisseur (5) de fréquence abaisseur,

**caractérisé en ce que**

- il est prévu un compteur (10) de fréquence conçu de manière à pouvoir être lu et ayant une entrée de compteur, qui est raccordée directement à la sortie de l'oscillateur (4), et une sortie (11) de valeur de comptage, pour la lecture d'une valeur de comptage, **en ce que**

- il est prévu une unité (12) de commande ayant une entrée, qui est reliée à la sortie (11) de la valeur de comptage, et une sortie, qui est raccordée à l'entrée (3) de sélection de l'oscillateur accordable, pour la sélection d'une bande de fréquence et **en ce que**

- le compteur (10) de fréquence conçu de manière à pouvoir être lu est un compteur binaire asynchrone ayant un registre (19, 20, 21, 22) de sortie volatil.

2. Dispositif de réglage d'asservissement suivant la revendication 1,
**caractérisé en ce que**
le convertisseur (5) de fréquence abaisseur est réalisé en compteur programmable.

3. Dispositif de réglage d'asservissement suivant la revendication 1 ou 2,
**caractérisé en ce que**
le convertisseur (5) de fréquence abaisseur est réalisé en diviseur multimodule, par lequel en moyenne un rapport de division fractionnel-rationnel est réglable.

4. Dispositif de réglage d'asservissement suivant l'une des revendications 1 à 3,
**caractérisé en ce que**
l'oscillateur (1) accordable et le compteur (10) de fréquence, conçu de manière à pouvoir être lu, sont intégrés sur un corps semiconducteur commun.

5. Dispositif de réglage d'asservissement suivant l'une des revendications 1 à 4,
**caractérisé en ce que**
l'unité (12) de commande et le convertisseur (5) de fréquence abaisseur ont respectivement une entrée de consigne, pour l'admission d'un signal de fréquence de consigne.

6. Dispositif de réglage d'asservissement suivant l'une des revendications 1 à 5,
**caractérisé en ce que**
**en ce que** le compteur (10) de fréquence, réalisé de manière accordable, a une entrée de commande, pour le réglage de la résolution de fréquence, qui est raccordée à une sortie de commande associée de l'unité (12) de commande.

## FIG 1

## FIG 2

## FIG 3

## FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5648744 A
- US 5182528 A
- EP 1189347 A1
- US 6512419 B1

**In der Beschreibung aufgeführte Nicht-Patentliteratur**

- **Y. Koo et al.** A Fully Integrated CMOS Frequency Synthesizer with Charge-Averaging Charge Pump and Dual-Path Loop Filter for PCS- and Cellular-CDMA Wireless Systems. *Journal of Solid-State Circuits,* Mai 2002, vol. 37 (5), 536-542